# EUROPÄISCHE PATENTSCHRIFT

(11) **EP 2 956 366 B1**
(45) Veröffentlichungstag und Bekanntmachung des Hinweises auf die Patenterteilung: **29.03.2017**
(21) Anmeldenummer: 14700905.4
(22) Anmeldetag: 20.01.2014
(51) Int. Cl.: B66B 5/00, B66B 13/22

(54) **SICHERHEITSKREISÜBERWACHUNG MIT WECHSELSPANNUNG**
SAFETY CIRCUIT MONITORING WITH ALTERNATING CURRENT
SURVEILLANCE DE CIRCUIT DE SÉCURITÉ AVEC TENSION ALTERNATIVE

(30) Priorität: 12.02.2013 EP 13154866
(43) Veröffentlichungstag der Anmeldung: 23.12.2015
(73) Patentinhaber: Inventio AG, 6052 Hergiswil (CH)
(72) Erfinder: LUSTENBERGER, Ivo, CH-6018 Buttisholz (CH)
(86) Internationale Anmeldenummer: PCT/EP2014/050979
(87) Internationale Veröffentlichungsnummer: WO 2014/124780

(56) Entgegenhaltungen:
- EP-A1- 0 903 314
- US-B1- 6 193 019

## Beschreibung

Die Erfindung betrifft eine Überwachungsanlage für Personentransportanlagen, die als Aufzug, Rolltreppe oder Fahrsteig ausgestaltet sind, solch eine Personentransportanlage und ein Verfahren für solch eine Personentransportanlage. Speziell betrifft die Erfindung das Gebiet der Aufzugsanlagen.

Aus der US 6,193,019 B1 ist eine Einrichtung zur Überwachung von Türen einer Aufzugsanlage, die auf mehreren Stockwerken vorgesehen sind, bekannt. Hierbei ist ein Sicherheitskreis mit einer Kette von Schaltern vorgesehen, die an Schlössern der Türen ausgestaltet sind. Parallel zu jedem dieser Schalter ist ein Widerstand geschaltet. Der jeweilige Widerstand ist bei geschlossenem Schalter überbrückt. Die Widerstandswerte sind als Produkt aus einer Zweierpotenz und einem Bezugswiderstand gebildet. Der Exponent, der eine nicht negative ganze Zahl ist, entspricht hierbei dem Stockwerk, auf dem die Tür angeordnet ist, auf die sich das Schloss mit dem zugeordneten Widerstand bezieht. Wenn ein oder mehrere Schalter geöffnet sind, dann kann somit aus der Summe der Widerstände an den offenen Schaltern, die den diesbezüglichen Gesamtwiderstand des offenen Sicherheitskreises angibt, berechnet werden, welche Schalter offen sind. Dies kann über eine geeignete Anzeigeeinrichtung ausgegeben werden.

Die aus der US 6,193,019 B1 bekannte Einrichtung zur Überwachung der Türen einer Aufzugsanlage hat den Nachteil, dass eine wesentliche Störung, wie ein Kurzschluss, die Funktionsweise des Sicherheitskreises so beeinträchtigen kann, dass eine oder mehrere offene Schlösser fälschlicherweise als geschlossen erkannt werden.

Aus der EP 1 440 930 A2 ist ein Türverschluss für eine Tür eines Aufzuges bekannt. Der bekannte Türverschluss weist ein Gehäuse und einen Riegel auf, der bezüglich der Tür in eine Verriegelungsstellung und in eine Freigabestellung überführbar ist. Der Riegel ist in dem Gehäuse gelagert. Hierbei weist der Verschluss eine manuell betätigbare Notentriegelung zur Überführung des Riegels in seine Freigabestellung auf, wobei die Notentriegelung einen Mitnehmer aufweist, der unter Überführung des Riegels in die Freigabestellung durch einen Notentriegelungsschlüssel betätigbar ist. Außerdem sind an oder in dem Gehäuse ein zwangsöffnender Sicherheitsschalter oder zumindest ein Teil einer entsprechenden elektrischen Sicherheitsschaltung und ein diesem beziehungsweise dieser zugeordneter manuell betätigbarer Mitnehmer zur Betätigung des Sicherheitsschalters beziehungsweise der Sicherheitsschaltung vorgesehen. Hierbei kann der Türverschluss derart ausgeführt sein, dass durch Betätigung der Notentriegelung zunächst der Sicherheitsschalter betätigt und zeitlich nachfolgend hierzu der Riegel in seine Freigabestellung überführt wird. Durch einen Sicherheitsstromkreis ist unter Schaltung des Sicherheitsschalters ein Normalbetrieb einer der Tür zugeordneten Einrichtung unterbrechbar und wieder aufnehmbar.

Aus der EP0903314 A1 ist eine Überwachungsanlage und ein Überwachungsverfahren gemäß dem Oberbegriff des Anspruchs 1, bzw. des Anspruchs 13 bekannt.

Speziell bei Aufzugsanlagen, die einen reduzierten Schachtkopf oder keinen Schachtkopf im Aufzugsschacht haben, ist eine Überwachung von Türverschlüssen, insbesondere Dreikantschlössern, von Schachttüren erforderlich. Dadurch kann festgestellt werden, ob jemand auf das Kabinendach gelangen konnte. Beim Öffnen eines Dreikantschlosses wird ein Sicherheitsschalter geöffnet, der einen Sicherheitskreis unterbricht. Wenn der Sicherheitsschalter, wie in der EP 1 440 930 A2 beschrieben, eine Rastfunktion aufweist, dann wird die Aufzugsanlage festgesetzt, bis ein Servicetechniker diese nach einer geeigneten Überprüfung wieder in Betrieb nimmt. Wenn nun aber beispielsweise ein Kurzschluss im Bereich des geöffneten Schalters vorhanden ist, dann wird die geöffnete Stellung nicht erkannt und es kann zu schwerwiegenden Unfällen kommen.

Aufgabe der Erfindung ist es, eine Überwachungseinrichtung für Personentransportanlagen, die als Aufzug, Rolltreppe oder Fahrsteig ausgestaltet sind, solch eine Personentransportanlage und ein Verfahren zur Überwachung solch einer Personentransportanlage anzugeben, die verbessert ausgestaltet sind. Speziell ist es eine Aufgabe der Erfindung, eine Überwachungseinrichtung für Personentransportanlagen, die als Aufzug, Rolltreppe oder Fahrsteig ausgestaltet sind, solch eine Personentransportanlage und ein Verfahren zur Überwachung solch einer Personentransportanlage anzugeben, die eine verbesserte Überwachung zumindest einer Einrichtung der Transporteinrichtung ermöglichen, wobei insbesondere Störungen des elektrischen Sicherheitskreises erkannt werden können.

Die Aufgabe wird durch eine Überwachungsanlage für Personentransportanlagen gelöst, welche als Aufzug, Rolltreppe oder Fahrsteig ausgestaltet sind. Die Überwachungsanlage beinhaltet zumindest eine Abfrageeinrichtung und zumindest ein, über einen elektrischen Sicherheitskreis mit der Abfrageeinrichtung verbundener Sicherheitsschalter, der zur Überwachung einer Einrichtung der Personentransporteinrichtung dient. Der Sicherheitsschalter weist eine erste Schaltstellung und eine zweite Schaltstellung auf. Zur Überprüfung des elektrischen Sicherheitskreises ist im elektrischen Sicherheitskreis eine stromrichtungsabhängige Einheit angeordnet. Die stromrichtungsabhängige Einheit weist eine stromrichtungsabhängige elektrische Eigenschaft auf. Sie sperrt oder reduziert daher den Stromfluss in Abhängigkeit der Polarität, beziehungsweise in einer, der beiden möglichen Durchflussrichtungen. Mittels der Abfrageeinrichtung kann eine Prüfspannung mit einer wechselnden Polarität an den elektrischen Sicherheitskreis angelegt werden. Ferner kann durch die Abfrageeinrichtung mindestens ein durch die Prüfspannung ermittelbarer Zustand des elektrischen Sicherheitskreises erfasst werden, wobei aus dem mindestens einen, durch die Abfrageeinrichtung erfassten Zustand und aus der, diesem Zustand zugehörenden Schaltstellung des Sicherheitsschalters mindestens ein Zustandssignal generierbar ist. Vorteilhaft ist es, dass in einer ersten Schaltstellung beziehungsweise einer ersten Abfolge der Schaltstellungen des zumindest einen Sicherheitsschalters der elektrische Sicherheitskreis über die stromrichtungsabhängige Einheit geschlossen ist.

Das Merkmal "ermittelbarer Zustand" umschreibt die von der Abfrageeinheit erfassbare Reaktion des Sicherheitskreises auf das Anlegen der Prüfspannung. Es können insgesamt vier Zustände erfasst werden. Wenn eine Prüfspannung mit wechselnder Polarität, beispielsweise eine sinusförmige Prüfspannung an den elektrischen Sicherheitskreis angelegt wird, erfasst die Abfrageeinrichtung als ersten ermittelbaren Zustand beispielsweise nur die positive Halbwelle der Prüfspannung. Ein zweiter ermittelbarer Zustand repräsentiert die Erfassung der ausschließlich negativen Halbwellen. Als dritter ermittelbarer Zustand kann die Erfassung der gesamten Prüfspannung (positive und negative Halbwellen) angesehen werden, während der vierte ermittelbare Zustand repräsentiert, dass trotz der Anlegung der Prüfspannung an den Sicherheitskreis keine Prüfspannung durch die Abfrageeinrichtung erfassbar ist.

Die vier ermittelbaren Zustände ermöglichen, Aussagen über den Zustand des Sicherheitskreises zu generieren und diese Aussagen in Form eines Zustandssignals auszugeben. Diese Aussagen können insbesondere dann eindeutig gemacht werden, wenn auch die Schaltstellung des Sicherheitsschalters bekannt ist. Aus dem vierten ermittelbaren Zustand lässt sich beispielsweise verifizieren, dass ein Sicherheitsschalter des Sicherheitskreises eine offene Schaltstellung aufweist. Aus dem vierten ermittelbaren Zustand lässt sich ferner auch herleiten, dass mindestens ein Element des Sicherheitskreises defekt ist und diesen unterbricht, wenn der Sicherheitsschalter eine geschlossene Schaltstellung meldet. Aus dem dritten ermittelbaren Zustand lässt sich ableiten, dass der Sicherheitskreis einen Kurzschluss aufweist, beispielsweise über den Schalter oder über die stromrichtungsabhängige Einheit. Sofern nur eine stromrichtungsabhängige Einheit im Sicherheitskreis eingesetzt ist, tritt je nach Polarität derselben im Sicherheitskreis nur entweder der erste oder der zweite ermittelbare Zustand auf, wenn der Sicherheitsschalter eine geschlossene Schaltstellung aufweist und der Sicherheitskreis intakt ist. Der erste ermittelbare Zustand und der zweite ermittelbare Zustand sind daher gleichwertig.

Je nach Auslegung der Überwachungseinrichtung kann beispielsweise über ein Bussystem das Zustandssignal von der Abfrageeinrichtung automatisch zu einer zentralen Steuerung geleitet oder von dieser bei der Abfrageeinrichtung abgefragt werden.

In vorteilhafter Weise ist die Abfrageeinrichtung ausgestaltet, die Prüfspannung in Form einer Wechselspannung durchgehend oder in gewissen Zeitabständen an den elektrischen Sicherheitskreis anzulegen. Beispielsweise kann die Prüfspannung aus einzelnen, vorzugsweise rechteckförmigen Spannungspulsen ausgebildet sein, die mit wechselnder Polarität an den elektrischen Sicherheitskreis angelegt werden. Hierdurch kann überprüft werden, ob der Sicherheitskreis die Abhängigkeit von der Polarität zeigt, die durch die stromrichtungsabhängige Einheit bedingt ist. Dadurch können auch Störungen des Sicherheitskreises erkannt werden.

Vorteilhaft ist es auch, dass von einer Bedienperson, insbesondere einem Servicetechniker, über eine Steuereinrichtung eine Testroutine für die Abfrageeinrichtung durchgeführt werden kann. In der Testroutine wird in jeder zu testenden Schaltstellung beziehungsweise Abfolge von Schaltstellungen des zumindest einen Sicherheitsschalters die Prüfspannung mit der wechselnden Polarität an den elektrischen Sicherheitskreis angelegt. Dadurch können zusätzlich die Sicherheitsschalter in ihrer Funktion bezüglich der möglichen Schaltstellungen überprüft werden.

Hierbei ist es ferner vorteilhaft, dass die stromrichtungsabhängige Einheit an dem letzten Sicherheitsschalter angeordnet ist, dass der letzte Sicherheitsschalter der einzige Sicherheitsschalter des Sicherheitskreises oder der letzte Sicherheitsschalter einer Reihe von mehreren Sicherheitsschaltern ist, die in einer Hinleitung des Sicherheitskreises angeordnet sind, und dass in der ersten Schaltstellung des ersten Sicherheitsschalters beziehungsweise der ersten Abfolge der Schaltstellungen der Reihe von mehreren Sicherheitsschaltern die Hinleitung über die stromrichtungsabhängige Einheit zum Schließen des elektrischen Sicherheitskreises mit einer Rückleitung verbunden ist. Durch die stromrichtungsabhängige Einheit wird ermöglicht, zu prüfen, ob die Hinleitung über den letzten Sicherheitsschalter beziehungsweise die Reihe von mehreren Sicherheitsschaltern geschlossen ist. Hierbei kann der Fall, dass die Hinleitung durch die geschlossenen Sicherheitsschalter geschlossen ist, von einem Fall unterschieden werden, in dem durch eine Störung die Sicherheitsschalter nicht mehr zu dem gewünschten Verhalten führen. Beispielsweise kann die Störung in einem Kurzschluss zwischen der Hinleitung und der Rückleitung bestehen, so dass ein oder mehrere Sicherheitsschalter überbrückt sind. Das Öffnen eines überbrückten Sicherheitsschalters führt dann nicht mehr zu einer elektrischen Öffnung des Sicherheitskreises. Durch die Überbrückung ist allerdings auch die stromrichtungsabhängige Einheit überbrückt. Die Prüfspannung mit der wechselnden Polarität führt somit bei dieser Störung nicht mehr zu einem von der Polarität beziehungsweise der Stromrichtung abhängigen Verhalten des Sicherheitskreises, wie es durch die überbrückte stromrichtungsabhängige Einheit ohne Störung der Fall ist. Somit wird erkannt, dass eine Störung des elektrischen Sicherheitskreises, nämlich in diesem Fall der Kurzschluss, vorliegt.

Vorteilhaft ist es, dass in der Reihe mit mehreren Sicherheitsschaltern nur an dem letzten Sicherheitsschalter die stromrichtungsabhängige Einheit angeordnet ist. Wenn solch eine Reihe mit mehreren Sicherheitsschaltern vorhanden ist, dann kann hierdurch in vorteilhafter Weise mit nur einer einzigen stromrichtungsabhängigen Einheit überprüft werden, ob durch eine Störung, wie einen Kurzschluss, ein oder mehrere Sicherheitsschalter überbrückt und somit außer Funktion sind. Zusätzlich oder alternativ ist es vorteilhaft, dass in der zweiten Schaltstellung des letzten Sicherheitsschalters beziehungsweise in einer anderen Abfolge der Schaltstellungen der Reihe von mehreren Sicherheitsschaltern, die sich von der ersten Abfolge unterscheidet, die Hinleitung unterbrochen ist. Beim Öffnen eines Sicherheitsschalters wird somit der Sicherheitskreis unterbrochen, wenn keine Störung vorliegt. Bei solch einer Ausgestaltung ergibt sich dann unabhängig von der Polarität der Prüfspannung eine Signalunterbrechung. Bei geschlossenen Sicherheitsschaltern kann hingegen die stromrichtungsabhängige Eigenschaft geprüft werden. Kann diese stromrichtungsabhängige elektrische Eigenschaft nicht erkannt werden, dann erkennt die Abfrageeinrichtung, dass eine Störung vorliegt. In jedem Fall, ob eine Störung vorliegt oder nicht, kann die Abfrageeinheit ein entsprechendes Zustandssignal generieren.

Speziell kann mit der einen Polarität der Prüfspannung geprüft werden, ob alle Sicherheitsschalter geschlossen sind oder ob zumindest ein Sicherheitsschalter geöffnet ist und mit beiden Polaritäten der Prüfspannung geprüft werden, ob eine Störung des elektrischen Sicherheitskreises vorliegt. Als Störung ist hierbei insbesondere ein Kurzschluss anzusehen. Dies ist durch eine Ausgestaltung der stromrichtungsabhängigen Einheit in Form einer Diode möglich. Hierdurch ergibt sich die Möglichkeit, mit einer vergleichsweise einfach generierten Prüfspannung und einer vergleichsweise einfach ausgestalteten Auswerteelektronik der Abfrageeinrichtung sowohl die Abfrage des Sicherheitskreises als auch die Überprüfung der Funktionsfähigkeit des Sicherheitskreises zu realisieren.

Bei einer weiteren möglichen Ausgestaltung ist es vorteilhaft, dass eine weitere stromrichtungsabhängige Einheit mit einer stromrichtungsabhängigen elektrischen Eigenschaft angeordnet ist, dass in einer zweiten Schaltstellung des letzten Sicherheitsschalters beziehungsweise in einer anderen Abfolge der Schaltstellungen der Reihe von mehreren Sicherheitsschaltern, die sich von der ersten Abfolge unterscheidet, ein mit der Abfrageeinrichtung verbundener Teil der Hinleitung auf eine Überbrückungsleitung geschaltet ist, so dass die stromrichtungsabhängige Einheit überbrückt ist und die Überbrückungsleitung über die weitere stromrichtungsabhängige Einheit mit der Rückleitung verbunden ist. Hierdurch können zusätzliche Abfragemöglichkeiten für die Abfrageeinrichtung ermöglicht werden. Denn bei zumindest einem offenen Sicherheitsschalter kann nun überprüft werden, ob der Sicherheitskreis die stromrichtungsabhängige Eigenschaft der stromrichtungsabhängigen Einheit oder die stromrichtungsabhängige Eigenschaft der weiteren stromrichtungsabhängigen Einheit zeigt.

Speziell ist es hierbei vorteilhaft, dass mit der einen Polarität der Prüfspannung geprüft wird, ob alle Sicherheitsschalter geschlossen sind und mit der anderen Polarität geprüft wird, ob zumindest ein Sicherheitsschalter geöffnet ist, und dass mit beiden Polaritäten der Prüfspannung geprüft wird, ob eine Störung des elektrischen Sicherheitskreises vorliegt. Insbesondere können hierbei als Störungen erkannt werden, ob ein Kurzschluss vorliegt oder ob ein Leitungsbruch vorliegt. Hierbei ist es außerdem von Vorteil, dass die stromrichtungsabhängige Einheit und die weitere stromrichtungsabhängige Einheit einen Stromfluss durch die Rückleitung bei zueinander entgegen gesetzten Polaritäten der Prüfspannung sperren. Liegt die stromrichtungsabhängige Einheit aufgrund der gegebenen ersten Schaltstellung beziehungsweise der ersten Abfolge von Schaltstellungen im elektrischen Strompfad des Sicherheitskreises, dann ergibt sich beispielsweise bei positiver Polarität der Prüfspannung ein Stromfluss, während bei negativer Polarität der Prüfspannung der Stromfluss gesperrt ist. Andererseits liegt in der zweiten Schaltstellung oder einer anderen Abfolge von Schaltstellungen die weitere stromrichtungsabhängige Einheit im Stromfluss des Sicherheitskreises, so dass beispielsweise bei positiver Polarität der Stromfluss gesperrt ist, während bei negativer Polarität ein Stromfluss besteht. Somit kann eindeutig zwischen einem offenen Sicherheitskreis und einem geschlossenen Sicherheitskreis unterschieden werden. Ferner wird in beiden Fällen auch die Abfrage ermöglicht, ob eine Störung vorliegt. Denn bei einem Leitungsbruch kommt es unabhängig von der Polarität der Prüfspannung dann zu keinem Stromfluss. Hingegen kommt es bei einem Kurzschluss unabhängig von der Polarität der Prüfspannung stets zu einem Stromfluss.

Vorteilhaft ist es, dass die stromrichtungsabhängige Einheit direkt an einem ersten Ausgang des letzten Sicherheitsschalters angeordnet ist. Speziell kann die stromrichtungsabhängige Einheit als Diode ausgestaltet sein. Dann ist es beispielsweise möglich, einen Anschluss der Diode direkt an einen Anschluss des Schalters oder dergleichen zu befestigen. Somit ist mit mechanischen Mitteln verhindert, dass ein Kurzschluss zwischen dem ersten Ausgang des letzten Sicherheitsschalters und der stromrichtungsabhängigen Einheit auftritt. Denkbar ist zwar auch, dass die stromrichtungsabhängige Einheit beabstandet zu dem ersten Ausgang des letzten Sicherheitsschalters angeordnet ist, dann muss solch eine Problematik mit anderen Mitteln aber zuverlässig verhindert werden. Vorteilhaft ist auch die Ausgestaltung des letzten Sicherheitsschalters zusammen mit einer Diode, die direkt bei einem Anschluss des ersten Ausgangs des letzten Sicherheitsschalters montiert ist, als bauliche Einheit. Speziell kann somit die stromrichtungsabhängige Einheit als Diode ausgestaltet sein oder zumindest eine Diode aufweisen.

Bei einer Ausgestaltung, bei der eine Überbrückungsleitung angeordnet ist, ist es entsprechend vorteilhaft, dass die weitere stromrichtungsabhängige Einheit direkt an dem zweiten Ausgang des letzten Sicherheitsschalters angeordnet ist. Hierbei können sowohl die stromrichtungsabhängige Einheit als auch die weitere stromrichtungsabhängige Einheit mit dem letzten Sicherheitsschalter eine bauliche Einheit bilden. Ferner ist es vorteilhaft, dass die weitere stromrichtungsabhängige Einheit durch eine Diode gebildet ist oder zumindest eine Diode aufweist.

Vorteilhaft ist es auch, dass die Überwachungseinrichtung eine dezentrale Steuereinrichtung aufweist, die die Abfrageeinrichtung umfasst oder an der Abfrageeinrichtung angeordnet ist, und dass die dezentrale Steuereinrichtung über ein Bussystem mit einer zentralen Steuerung verbunden ist. Beispielsweise kann auf jedem Stockwerk solch eine dezentrale Steuereinrichtung vorhanden sein, die zusammen mit der jeweiligen Abfrageeinrichtung ein oder mehrere Sicherheitsschalter überwacht und abfragt. An die zentrale Steuerung kann dann beim Auftreten eines Fehlers beispielsweise das Stockwerk gemeldet werden.

Bei einer weiteren möglichen Ausgestaltung ist es vorteilhaft, dass eine Steuereinrichtung vorhanden ist, die die Abfrageeinrichtung umfasst oder an der Abfrageeinrichtung angeordnet ist, und dass die Sicherheitsschalter an der Abfrageeinrichtung und/oder dezentral verteilt angeordnet sind. Bei dieser Ausgestaltung können die Sicherheitsschalter insbesondere über mehrere Stockwerke verteilt angeordnet sein. Hierbei reicht gegebenenfalls eine einzige Steuereinrichtung, die an einer Steuerung angeordnet oder in eine Steuerung integriert sein kann.

Somit ist insbesondere die sichere Abfrage eines Dreikantschlosses oder eines anderen Schlosses über einen Sicherheitsschalter des Sicherheitskreises möglich, wobei je nach Ausgestaltung auch eine einfache Zweidrahtleitung zum Einsatz kommen kann. Hierbei können Unterbrüche und Kurzschlüsse auf der Leitung sicher erkannt werden. Ferner kann in jedem Fehlerfall ein offenes Dreikantschloss beziehungsweise ein offener Schalter sicher erkannt werden. Zu diesem Zweck kann insbesondere eine als Diode ausgestaltete stromrichtungsabhängige Einheit so nah wie möglich bei einem Schaltkontakt des Dreikantschlosses platziert werden. Die Abfrage des Schaltzustandes kann hierbei über eine positiv und negativ angelegte Speisespannung, aus der sich die Prüfspannung ergibt, geschehen. Dies kann sporadisch oder mit schnell wechselnder Frequenz geschehen. Liegt die Prüfspannung in Durchlassrichtung der Diode an, dann wird der geschlossene Zustand des Sicherheitsschalters erkannt. In Sperrrichtung kann im Fall eines Kurzschlusses der Leitung ein Stromfluss für beide Polaritäten erkannt werden. Bei einem Unterbruch oder einem offenen Sicherheitsschalter kann hingegen eine Unterbrechung erkannt werden. Damit können alle Zustände unterschieden werden und ein Fehlverhalten kann sofort erkannt werden. Auch ein Defekt der stromrichtungsabhängigen Einheit, insbesondere ein Defekt der Diode, kann sicher erkannt werden, wobei es sich bei dem Defekt um einen Kurzschluss oder einen Unterbruch handeln kann. Wenn zusätzlich ein Leitungsunterbruch erkannt werden soll, dann können die Sicherheitsschalter in Form von Umschaltern mit zwei Ausgängen zum Einsatz kommen. Hierbei können insbesondere die beiden Ausgänge des letzten Sicherheitsschalters über zwei antiparallele Dioden, von denen eine an dem ersten Ausgang und die andere an dem zweiten Ausgang angeordnet ist, mit der Rückleitung verbunden werden. Somit können alle vier genannten Zustände unterschieden werden.

Die Abfrageeinrichtung oder eine Steuereinrichtung mit der Abfrageeinrichtung kann somit auch zentral in einer Steuerung, insbesondere einer Aufzugssteuerung, angeordnet sein. Die Abfrageeinrichtung oder die Steuereinrichtung kann aber auch auf jeder Etage vorgesehen sein und beispielsweise in ein RFID-Kartenlesegerät auf der jeweiligen Etage integriert sein und dessen Schnittstelle zum Bus mitbenutzen. Bei einer weiteren möglichen Ausgestaltung kann die Abfrageeinrichtung auch auf jeder Etage beziehungsweise jedem Stockwerk im Dreikantschloss installiert sein und über eine eigene Schnittstellung mit dem Bus verbunden sein.

Als Vorteil ergibt sich somit auch eine platzsparende Ausgestaltung. Ein weiterer Vorteil ist, dass die Lösung kostengünstig realisiert werden kann, da gegebenenfalls nur ein Öffner anstelle eines Umschalters erforderlich ist und gegebenenfalls nur zwei Drähte ausreichen können. Außerdem kann eine verbesserte Fehlererkennung realisiert werden.

Ferner kann eine verbesserte Verarbeitung und eine intelligentere Reaktion, insbesondere im Bereich der Steuerung, erzielt werden, wenn die gewonnen Daten beispielsweise mit einer aktuellen Kabinenposition oder anderen Informationen verknüpft werden.

Ferner kann mit mechanischen Mitteln verhindert werden, dass ein Kurzschluss zwischen dem Ausgang des Sicherheitsschalters und der stromrichtungsabhängige Einheit, insbesondere der Diode, auftreten kann, indem eine direkte Anordnung, insbesondere in einer baulichen Einheit, realisiert wird. Hierbei kann konstruktiv sichergestellt werden, dass der Sicherheitsschalter bei geöffnetem Dreikantschloss zumindest auf der Hinleitung sicher unterbrochen ist, was einer Zwangsöffnung entspricht.

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigen:
Figur 1 eine Überwachungsanlage für eine Personentransportanlage in einer auszugsweisen, schematischen Darstellung entsprechend einem ersten Ausführungsbeispiel der Erfindung;
Figur 2 eine Überwachungsanlage für eine Personentransportanlage in einer auszugsweisen, schematischen Darstellung entsprechend einem zweiten Ausführungsbeispiel der Erfindung;
Figur 3 eine Überwachungsanlage für eine Personentransportanlage in einer auszugsweisen, schematischen Darstellung entsprechend einem dritten Ausführungsbeispiel der Erfindung;
Figur 4 eine Überwachungsanlage für eine Personentransportanlage in einer auszugsweisen, schematischen Darstellung entsprechend einem vierten Ausführungsbeispiel der Erfindung und
Figur 5 eine Personentransportanlage mit einer Überwachungsanlage entsprechend einem fünften Ausführungsbeispiel der Erfindung in einer auszugsweisen, schematischen Darstellung.

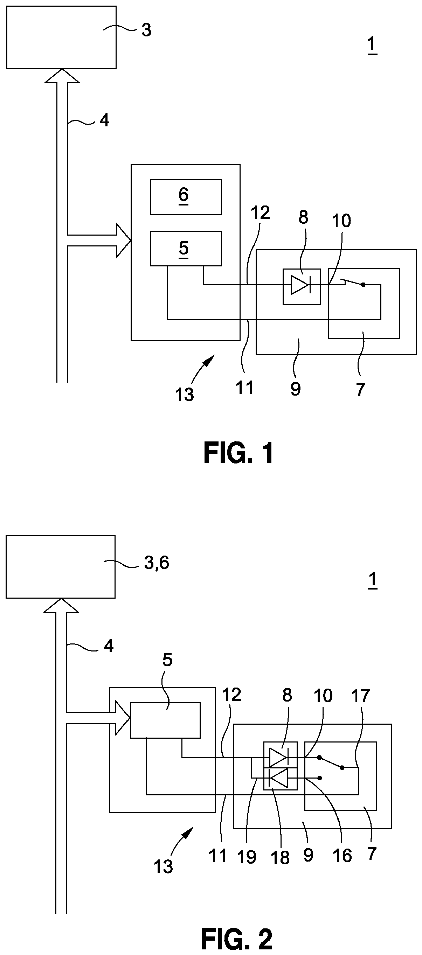

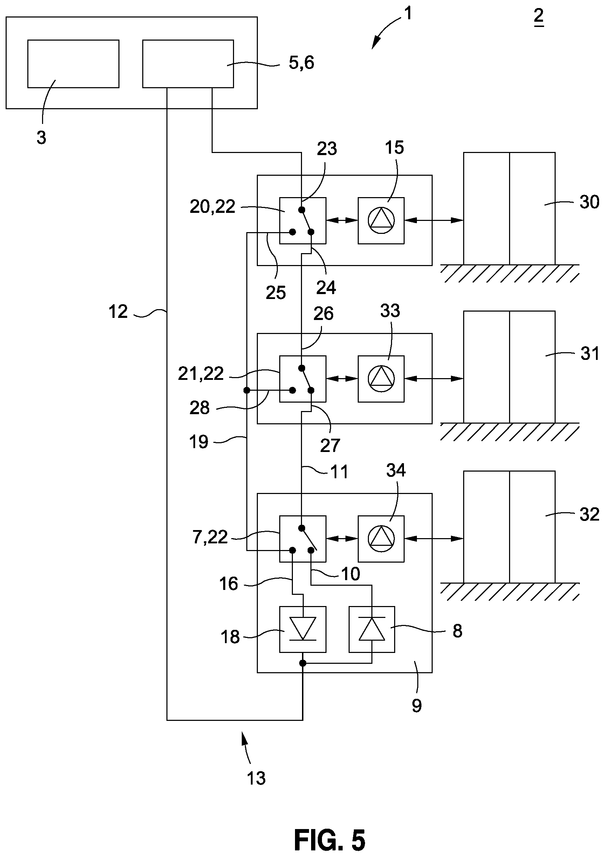

Figur 1 zeigt eine Überwachungsanlage 1 für eine Personentransportanlage, die als Aufzug beziehungsweise Aufzugsanlage, Rolltreppe oder Fahrsteig ausgestaltet ist, in einer auszugsweisen, schematischen Darstellung entsprechend einem ersten Ausführungsbeispiel. Eine solche Personentransportanlage 2 ist etwas detaillierter in der Figur 5 dargestellt.

Die Überwachungsanlage 1 der Figur 1 weist eine zentrale Steuerung 3 auf, die in eine Aufzugssteuerung oder dergleichen integriert sein kann oder an einer Aufzugssteuerung oder dergleichen angeordnet ist. Die zentrale Steuerung 3 ist hierbei an ein Bussystem 4 angebunden. Das Bussystem 4 kann hierbei als gemeinsames Bussystem für alle Daten beziehungsweise Signale und Zustandssignale der Personentransportanlage dienen. Es kann aber auch ein exklusives Bussystem 4 für die Überwachungsanlage 1 zur Verfügung stehen.

Die Überwachungsanlage 1 weist eine Abfrageeinrichtung 5 und eine dezentrale Steuereinrichtung 6 auf. Die Abfrageeinrichtung 5 ist hierbei an der dezentralen Steuereinrichtung 6 angeordnet. Die Abfrageeinrichtung 5 kann auch in die dezentrale Steuereinrichtung 6 integriert sein. Die Abfrageeinrichtung 5 und die dezentrale Steuereinrichtung 6 sind direkt oder indirekt mit dem Bussystem 4 verbunden.

Die Überwachungsanlage 1 weist außerdem einen Sicherheitsschalter 7 und eine stromrichtungsabhängige Einheit 8 mit einer stromrichtungsabhängigen elektrischen Eigenschaft auf. In diesem Ausführungsbeispiel ist die stromrichtungsabhängige Einheit 8 durch eine Diode 8 ausgebildet. Die stromrichtungsabhängige Einheit 8 bildet hierbei mit dem Sicherheitsschalter 7 eine bauliche Einheit 9. Hierbei kann ein Anschluss der Diode 8 direkt an einen Ausgang 10 des Sicherheitsschalters 7 montiert seine. Zusammen mit einer Hinleitung 11 und einer Rückleitung 12 ist ein elektrischer Sicherheitskreis 13 gebildet, der über die Abfrageeinrichtung 5 hinsichtlich seines Zustands abfragt werden kann.

Wenn der Sicherheitsschalter 7 geöffnet wird, dann ist der elektrische Sicherheitskreis 13 unterbrochen, so dass kein Stromfluss durch den elektrischen Sicherheitskreis 13 möglich ist. Unabhängig von einer Polarität einer an den elektrischen Sicherheitskreis 13 angelegten Prüfspannung ergibt sich somit kein Stromfluss. Dadurch erkennt die Abfrageeinrichtung 5, dass eine Einrichtung 15 (Figur 5), insbesondere ein Türschloss 15, geöffnet worden ist. Somit kann die Einrichtung 15 der Personentransportanlage 2 überwacht werden.

Wenn der Sicherheitsschalter 7 geschlossen ist, dann wird bei wechselnder Polarität der Prüfspannung nur in Durchlassrichtung der Diode 8 ein Stromfluss erzeugt. Dadurch kann die Abfrageeinrichtung 5 erfassen, dass der Sicherheitsschalter 7 geschlossen ist. Ferner kann die Abfrageeinrichtung 5 dadurch erfassen, dass kein Kurzschluss zwischen der Hinleitung 11 und der Rückleitung 12 besteht. Denn bei einem Kurzschluss zwischen der Hinleitung 11 und der Rückleitung 12 ergibt sich unabhängig von der Polarität der Prüfspannung ein Stromfluss.

Somit kann die Abfrageeinrichtung 5 zuverlässig eine Störung, insbesondere einen Kurzschluss, des elektrischen Sicherheitskreises 13 erfassen. Somit ist eine zuverlässige Erfassung eines Öffnens des Sicherheitsschalters 7 möglich, da sich die Eigenschaften des elektrischen Sicherheitskreises 13 bei geschlossenem Sicherheitsschalter 7 und des elektrischen Sicherheitskreises 13 bei einem Kurzschluss zuverlässig voneinander unterscheiden lassen. Störungen beziehungsweise ein einwandfreier Zustand des elektrischen Sicherheitskreises 13 können von der Abfrageeinrichtung 5 somit erfasst und beispielsweise in Form eines Zustandssignals an die Steuereinrichtung 6 ausgegeben werden.

Figur 2 zeigt eine Überwachungsanlage 1 der Personentransportanlage 2 (Figur 5) in einer auszugsweisen, schematischen Darstellung entsprechend einem zweiten Ausführungsbeispiel. In diesem Ausführungsbeispiel ist die Steuereinrichtung 6 als zentrale Steuereinrichtung 6 ausgestaltet und in die zentrale Steuerung 3 integriert. Die Abfrageeinrichtung 5 ist über das Bussystem 4 mit der zentralen Steuereinrichtung 6 verbunden. Der Sicherheitsschalter 7 weist in diesem Ausführungsbeispiel einen ersten Ausgang 10 und einen zweiten Ausgang 16 auf, die wechselweise mit einem Eingang 17 des Sicherheitsschalters 7 verbunden sind. In der ersten Schaltstellung, in der der Eingang 17 mit dem ersten Ausgang 10 verbunden ist, ist die Hinleitung 11 über die stromrichtungsabhängige Einheit 8 mit der Rückleitung 12 verbunden. Dies bedeutet in diesem Ausführungsbeispiel, dass die Einrichtung 15 geschlossen ist, was keine sicherheitsrelevante Aktion erfordert. In einer zweiten Schaltstellung des Sicherheitsschalters 7, in der der Eingang 17 mit dem zweiten Ausgang 16 verbunden ist, ist die Hinleitung 11 über eine weitere stromrichtungsabhängige Einheit 18 mit einer stromrichtungsabhängigen elektrischen Eigenschaft und eine Überbrückungsleitung 19 mit der Rückleitung 12 verbunden. Die Überbrückungsleitung 19 überbrückt hierbei in der zweiten Schaltstellung des Sicherheitsschalters 7 die stromrichtungsabhängige Einheit 8.

In diesem Ausführungsbeispiel ist die weitere stromrichtungsabhängige Einheit 18 durch eine zweite Diode 18 ausgebildet. Hierbei sind die erste Diode 8 und die zweite Diode 18 in Bezug auf einen Stromfluss durch den elektrischen Sicherheitskreis 13 bei entsprechend geschaltetem Sicherheitsschalter 7 gegenläufig (antiparallel) zueinander angeordnet. In Abhängigkeit von der Schaltstellung des Sicherheitsschalters 7 liegt aber jeweils nur eine der Dioden 8, 18 im geschlossenen Stromkreis.

Die weitere stromrichtungsabhängige Einheit 18 ist direkt an dem zweiten Ausgang 16 des Sicherheitsschalters 7 angeordnet. In diesem Ausführungsbeispiel bilden die stromrichtungsabhängige Einheit 8, die weitere stromrichtungsabhängige Einheit 18 und der Sicherheitsschalter 7 eine bauliche Einheit 9. Beispielsweise kann ein Anschluss der Diode 18 direkt an dem zweiten Ausgang 16 des Sicherheitsschalters 7 montiert sein. Hierdurch wird eine Störung, insbesondere ein Kabelbruch, zwischen den stromrichtungsabhängigen Einheiten 8, 18 und dem Sicherheitsschalter 7 von vornherein ausgeschlossen.

Die stromrichtungsabhängigen Einheiten 8, 18 sind in diesem Ausführungsbeispiel durch eine erste Diode 8 und eine zweite Diode 18, gebildet. In einer abgewandelten Ausgestaltung können die stromrichtungsabhängigen Einheiten 8, 18 aber auch andere oder zusätzliche Bauteile, insbesondere Widerstände, aufweisen. Denkbar ist auch eine Ausgestaltung, bei der beispielsweise die stromrichtungsabhängige Einheit 8 gegeneinander orientierte Dioden aufweist, wodurch bei geschlossenem Stromkreis in Abhängigkeit von der Polarität der Prüfspannung beispielsweise unterschiedliche Widerstandswerte abgefragt werden können. Hierfür können zu den beiden gegenläufigen Dioden einer einzigen stromrichtungsabhängigen Einheit 8 unterschiedlich große Widerstände in Reihe geschaltet sein. In entsprechender Weise kann sich eine derartige stromrichtungsabhängige Eigenschaft nicht nur auf einen Ohm'schen Widerstand, sondern auch auf eine Impedanz beziehen. Ferner ergibt sich somit, dass die stromrichtungsabhängige Eigenschaft der stromrichtungsabhängigen Einheit 8 nicht notwendigerweise eine Sperrung des Stroms, also einen unendlich großen Widerstand, für eine der beiden Polaritäten der Prüfspannung bedeutet.

In entsprechender Weise kann auch die weitere stromrichtungsabhängige Einheit 18 nicht nur aus einer Diode 18, sondern auch aus zusätzlichen oder anderen Bauteilen bestehen.

Bei der anhand der Figur 2 beschriebenen Ausgestaltung der stromrichtungsabhängigen Einheiten 8, 18 kann mit der einen Polarität der Prüfspannung, bei der die erste Diode 8 in Durchflussrichtung geschaltet ist, überprüft werden, ob der Stromkreis geschlossen ist. Ist zusätzlich bei entgegen gesetzter Polarität der Prüfspannung der Stromkreis gesperrt, dann liegt weder ein Leitungsbruch noch ein Kurzschluss vor und die Abfrageeinrichtung 5 erfasst somit die erste Schaltstellung des Sicherheitsschalters 7 bei einem störungsfreien Betrieb.

Liegt ein Kurzschluss vor, dann ergibt sich sowohl bei positiver Polarität als auch bei negativer Polarität ein Stromfluss, so dass eine Störung, nämlich ein Kurzschluss, erfasst wird. Ergibt sich hingegen weder bei positiver Polarität noch bei negativer Polarität ein Stromfluss, dann liegt ein Leitungsbruch vor.

Ergibt sich hingegen bei einer Polarität, in der die zweite Diode 18 in Durchflussrichtung geschaltet ist, ein Stromfluss und in Gegenrichtung kein Stromfluss, dann liegt weder ein Kurzschluss noch ein Leitungsbruch vor und die Abfrageeinrichtung 5 erfasst, dass sich der Sicherheitsschalter 7 in der zweiten Schaltstellung befindet.

Somit kann in diesem Ausführungsbeispiel die Abfrageeinrichtung 5 jeden der vier genannten Zustände erfassen und diese auch voneinander unterscheiden.

Bei den anhand der Figur 1 und 2 beschriebenen Ausgestaltungen ist der Sicherheitsschalter 7 jeweils der einzige und somit zwangsläufig formal der letzte Sicherheitsschalter 7. Es kann jedoch auch mehr als ein Sicherheitsschalter 7 in einem elektrischen Sicherheitskreis 13, der von der Abfrageeinrichtung 5 abgefragt werden kann, angeordnet sein. Störungen beziehungsweise ein einwandfreier Zustand des elektrischen Sicherheitskreises 13 können von der Abfrageeinrichtung 5 somit erfasst und beispielsweise in Form eines Zustandssignals an die Steuereinrichtung 6 ausgegeben werden.

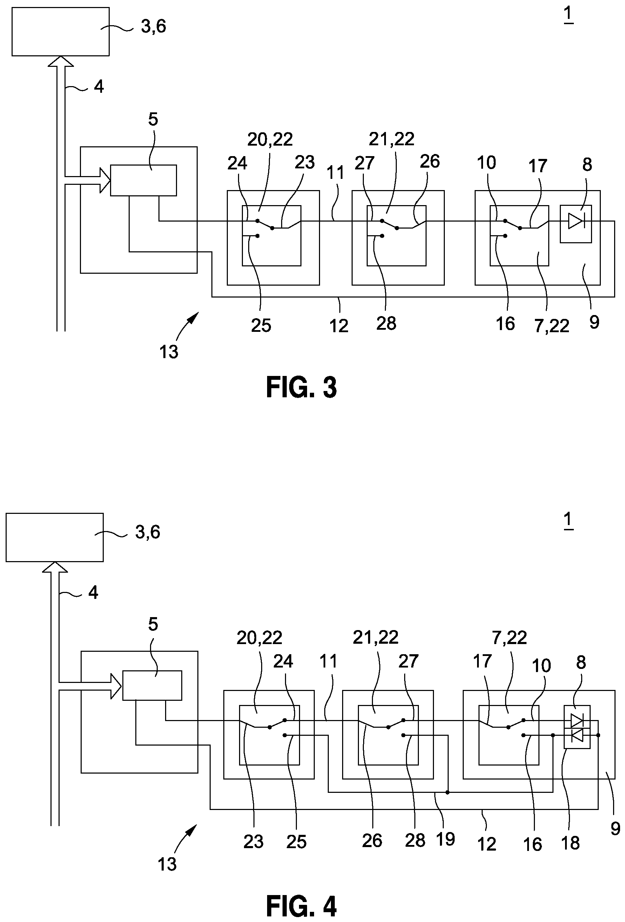

Figur 3 zeigt eine Überwachungseinrichtung 1 für die Personentransportanlage 2 (Figur 5) in einer auszugsweisen, schematischen Darstellung entsprechend einem dritten Ausführungsbeispiel. In diesem Ausführungsbeispiel ist die Abfrageeinrichtung 5 über das Bussystem 4 mit der zentralen Steuereinrichtung 6 verbunden. Ferner weist der Sicherheitsschalter 7 einen Ausgang 10 auf, während der Ausgang 16 offen ist. Außerdem sind weitere Sicherheitsschalter 20, 21 angeordnet. Die Sicherheitsschalter 7, 20, 21 bilden eine Reihe 22 von Sicherheitsschaltern 7, 20, 21, die in der Hinleitung 11 angeordnet sind. Der Sicherheitsschalter 7 ist der letzte Sicherheitsschalter 7 in der Reihe 22, der über die stromrichtungsabhängige Einheit 8 mit der Rückleitung 12 verbunden ist.

Der Sicherheitsschalter 20 weist einen Eingang 23 und Ausgänge 24, 25 auf, wobei der Ausgang 25 offen ist. Der Sicherheitsschalter 21 weist einen Eingang 26 und Ausgänge 27, 28 auf, wobei der Ausgang 28 offen ist.

In der Figur 3 ist eine erste Abfolge von Schaltstellungen der Reihe 22 von Sicherheitsschaltern 7, 20, 21 dargestellt. In dieser ersten Abfolge sind alle Sicherheitsschalter 7, 20, 21 geschlossen. Dies bedeutet, dass beim Sicherheitsschalter 7 der Eingang 17 mit dem Ausgang 10 verbunden ist, dass beim Sicherheitsschalter 20 der Eingang 23 mit dem Ausgang 24 verbunden ist und dass beim Sicherheitsschalter 21 der Eingang 26 mit dem Ausgang 27 verbunden ist. Der Stromkreis im elektrischen Sicherheitskreis 13 ist daher geschlossen.

Wenn die Prüfspannung mit der Polarität an den elektrischen Sicherheitskreis 13 angelegt wird, in der die Diode 8 in Durchlassrichtung liegt, dann ergibt sich ein Stromfluss. In der anderen Polarität sperrt die Diode 8, so dass sich kein Stromfluss ergibt. Somit kann ein Kurzschluss zwischen der Hinleitung 1 und der Rückleitung 12 erkannt werden. Denn bei einem Kurzschluss ergibt sich für beide Polaritäten der Prüfspannung ein Stromfluss.

Wenn einer der Sicherheitsschalter 7, 20, 21 in der Reihe 22 geöffnet wird, dann ergibt sich für beide Polaritäten der Prüfspannung kein Stromfluss. Somit kann der geschlossene elektrische Sicherheitskreis 13 zuverlässig von einem Kurzschluss unterschieden werden. Dadurch ergibt sich eine zuverlässige Erfassung, ob beispielsweise das Türschloss 15 (Figur 5) geöffnet wird. Störungen beziehungsweise ein einwandfreier Zustand des elektrischen Sicherheitskreises 13 können von der Abfrageeinrichtung 5 somit erfasst und beispielsweise in Form eines Zustandssignals an die Steuereinrichtung 6 ausgegeben werden.

Figur 4 zeigt eine Überwachungsanlage für die Personentransportanlage 2 (Figur 5) in einer auszugsweisen, schematischen Darstellung entsprechend einem vierten Ausführungsbeispiel. In diesem Ausführungsbeispiel ist im Unterschied zu dem anhand der Figur 3 beschriebenen dritten Ausführungsbeispiel zusätzlich eine Überbrückungsleitung 19 angeordnet. Hierbei ist der erste Ausgang 24 des Sicherheitsschalters 20 mit dem Eingang 26 des Sicherheitsschalters 21 verbunden. Der erste Ausgang 27 des Sicherheitsschalters 21 ist mit dem Eingang 17 des Sicherheitsschalters 7 verbunden. Ferner ist der Ausgang 10 des Sicherheitsschalters 7 über die Diode 8 mit der Rückleitung 12 verbunden.

Der zweite Ausgang 25 des Sicherheitsschalters 20, der zweite Ausgang 28 des Sicherheitsschalters 21 und der zweite Ausgang 16 des Sicherheitsschalters 7 sind über die Überbrückungsleitung 19 miteinander verbunden. Ferner ist der zweite Ausgang 16 des Sicherheitsschalters 7 über die weitere stromrichtungsabhängige Einheit 18 mit der Rückleitung 12 verbunden.

In der Figur 4 ist die erste Abfolge von Schaltstellungen der Sicherheitsschalter 7, 20, 21, dargestellt. In der ersten Abfolge von Schaltstellungen ist die ununterbrochene Hinleitung 11 über die stromrichtungsabhängige Einheit 8 mit der Rückleitung 12 verbunden, so dass der elektrische Sicherheitskreis 13 auf diese Weise geschlossen ist. Beim Anlegen der Prüfspannung mit der wechselnden Polarität ergibt sich somit in Bezug auf die Orientierung der Diode 8 ein entsprechend reduziertes Stromsignal. Die Orientierung der Diode 8 bedingt also ein bestimmtes Sperr- und Durchlassverhalten, das durch die Prüfspannung mit der wechselnden Polarität abgefragt werden kann. In jeder anderen Abfolge von Schaltstellungen ist zumindest ein Sicherheitsschalter 7, 20, 21 der Reihe 22 geöffnet. Somit wird die stromrichtungsabhängige Einheit 8 über die Überbrückungsleitung 19 und die weitere stromrichtungsabhängige Einheit 18 überbrückt. Damit liegt die weitere stromrichtungsabhängige Einheit 18 im dann geschlossenen Stromkreis, so dass sich in Bezug auf die Polaritäten des Prüfsignals nun gerade das umgekehrte Sperr- und Durchlassverhalten ergibt.

Sowohl in der ersten Abfolge von Schaltstellungen als auch in einer anderen Abfolge von Schaltstellungen kann aus der Abwesenheit eines Stromsignals bei sowohl positiver als auch negativer Polarität auf eine Störung, insbesondere einen Leitungsbruch, geschlossen werden. Dies wird entsprechend von der Abfrageeinrichtung 5 ausgewertet.

Ergibt sich hingegen sowohl bei positiver Polarität als auch bei negativer Polarität stets ein Stromsignal, dann kann auf einen Kurzschluss zwischen der Hinleitung 11 und der Rückleitung 12 geschlossen werden. Dies wird ebenfalls von der Abfrageeinrichtung 5 ausgewertet.

Der Unterschied zwischen der ersten Abfolge der Schaltstellungen, die in der Figur 4 dargestellt ist, und jeder anderen Abfolge der Schaltstellungen ergibt sich aus der Prüfung, ob nur bei positiver Polarität oder nur bei negativer Polarität der Prüfspannung ein Stromfluss erfasst wird. Somit kann zuverlässig erfasst werden, ob die erste Abfolge der Schaltstellungen der Sicherheitsschalter 7, 20, 21 vorliegt, wobei zugleich störungsbedingte Einflüsse ausgeschlossen werden können. Störungen beziehungsweise ein einwandfreier Zustand des elektrischen Sicherheitskreises 13 können von der Abfrageeinrichtung 5 somit erfasst und beispielsweise in Form eines Zustandssignals an die Steuereinrichtung 6 ausgegeben werden.

Figur 5 zeigt eine Personentransportanlage 2 mit einer Überwachungsanlage 1 entsprechend einem fünften Ausführungsbeispiel in einer auszugsweisen, schematischen Darstellung. In diesem Ausführungsbeispiel ist eine zentrale Abfrageeinrichtung 5 vorhanden, die in eine zentrale Steuereinrichtung 6 integriert ist. Ferner ist die Steuereinrichtung 6 an der zentralen Steuerung 3 angeordnet. Die Steuereinrichtung 6 kann auch in die Steuerung 3 integriert sein. Bei der Steuerung 3 handelt es sich in diesem Ausführungsbeispiel um eine Aufzugssteuerung 3.

Die Personentransportanlage 2 ist in diesem Ausführungsbeispiel als Aufzugsanlage 2 ausgebildet. Hierbei weist die Aufzugsanlage 2 auf jedem Stockwerk Türen 30, 31, 32 auf. Die Einrichtung 15 ist der Tür 30 zugeordnet. Bei der Einrichtung 15 handelt es sich in diesem Ausführungsbeispiel um ein Dreikantschloss, das beispielsweise von einem Servicetechniker geöffnet werden kann. Bei geöffnetem Dreikantschloss 15 kann die Tür 30 manuell geöffnet werden, so dass ein Zutritt zu einem Aufzugsschacht möglich ist. Insbesondere kann hierdurch ein Servicetechniker oder eine Wartungsperson auf das Kabinendach einer Aufzugskabine gelangen. Entsprechend sind Einrichtungen 33, 34 angeordnet, die als Dreikantschlösser 33, 34 ausgestaltet sind. Das Dreikantschloss 33 ist der Tür 31 zugeordnet. Das Dreikantschloss 34 ist der Tür 32 zugeordnet.

An jedem Dreikantschloss 15, 33, 34 ist einer der Sicherheitsschalter 7, 20, 21 angeordnet. Hierbei können die Sicherheitsschalter 7, 20, 21 auch in das jeweilige Dreikantschloss 15, 33, 34 integriert sein.

In diesem Ausführungsbeispiel kann mit einer einzigen Abfrageeinrichtung 5 eine Überwachung mehrerer Einrichtungen 15, 33, 34 erfolgen, die an der Abfrageeinrichtung 5 angeordnet und/oder über die Stockwerke dezentral verteilt sind.

Im Unterschied zu dem anhand der Figur 5 beschriebenen Ausführungsbeispiel können bei den anhand der Figur 1 bis 4 beschriebenen Ausführungsbeispielen auch mehrere Abfrageeinrichtungen vorhanden sein, die der Abfrageeinrichtung 5 entsprechen. Hierbei kann jede Abfrageeinrichtung einem Sicherheitsschalter oder einer Reihe von Sicherheitsschaltern zugeordnet sein.

Durch eine von der Abfrageeinrichtung 5 gemachte Abfrage des elektrischen Sicherheitskreises 13 kann somit eine Abfrage der Schaltstellungen der Sicherheitsschalter 7, 20, 21 und/oder eine Prüfung des elektrischen Sicherheitskreises 13 erfolgen. Je nach Ausgestaltung der Überwachungsanlage 1 kann dies gleichzeitig oder zeitlich versetzt erfolgen.

Bei den beschriebenen Ausführungsbeispielen werden zur besseren Verständlichkeit der Beschreibung Eingänge 17, 23, 26 und Ausgänge 10, 16, 24, 25, 27, 28 der Sicherheitsschalter 7, 20, 21 betrachtet. Diese Bezeichnungen sind jedoch unter dem Gesichtspunkt der Verständlichkeit gemacht. Die Eingänge können begrifflich ebenso als Ausgänge bezeichnet werden und umgekehrt. Ferner können die Sicherheitsschalter 7, 20, 21 auch abgewandelt ausgestaltet sein. Beispielsweise können bei einer abgewandelten Ausgestaltung auch Taster oder Kippschalter, die ein ausdrückliches Zurücksetzen verlangen, zum Einsatz kommen. Ferner können die Sicherheitsschalter 7, 20, 21 beispielsweise auch auf einer elektrischen, elektronischen, fotoelektrischen, elektromagnetischen oder sonstigen Wirkungsweise basieren oder sich Komponenten mit einer dieser Wirkungsweisen zu Nutze machen.

Ferner kann die Abfrageeinrichtung 5 die Prüfspannung in Form einer Wechselspannung durchgehend oder in gewissen Zeitabständen an den elektrischen Sicherheitskreis anlegen. Hierbei ist insbesondere eine Testroutine durchführbar, in der in jeder zu testenden Schaltstellung beziehungsweise Abfolge von Schaltstellungen des zumindest einen Sicherheitsschalters 7, 20, 21 die Prüfspannung mit der wechselnden Polarität an den elektrischen Sicherheitskreis 13 angelegt wird. Hierdurch kann ein Servicetechniker die Funktionsfähigkeit der Überwachungsanlage 1 gezielt überprüfen. Insbesondere kann die Funktion der Überwachungsanlage 1 dahingehend geprüft werden, dass nicht nur das Öffnen und Schließen der jeweiligen Einrichtung 15, 33, 34 zuverlässig überwacht wird, sondern auch Störungen, insbesondere ein Leitungsbruch oder ein Kurzschluss, zuverlässig erkannt werden. Solche Störungen kann der Servicetechniker während der Testroutine auf geeignete Weise simulieren. Hierfür können gegebenenfalls auch ein Kurzschlusstaster und ein Unterbrechungstaster in den elektrischen Sicherheitskreis 13 integriert sein, die entsprechend dem Ablauf der Testroutine von der Serviceperson betätigt werden.

Bei einer Ausgestaltung der Überwachungsanlage 1, wie sie anhand der Figur 1 und 3 beschrieben ist, kann eine den elektrischen Sicherheitskreis 13 unterbrechende Störung, die beispielsweise ein Leitungsbruch sein kann, zunächst wie ein geöffneter Sicherheitsschalter 7, 20, 21 behandelt werden. Dies bedeutet, dass der Betrieb der Personentransportanlage 2 unterbrochen wird. Eine Serviceperson kann dann überprüfen, ob ein geöffneter Sicherheitsschalter 7, 20, 21 oder eine Störung die Ursache für die Betriebsunterbrechung ist.

Ferner wird bei den anhand der Figuren 2, 4, 5 beschriebenen Ausführungsbeispielen auch eine Erkennung einer Störung auf der Überbrückungsleitung 19 ermöglicht. Falls auf einen gestörten Teil der Überbrückungsleitung 19 geschaltet wird, dann wird beispielsweise bei einem Leitungsbruch unabhängig von der Polarität der Prüfspannung das gleiche Verhalten des Sicherheitskreises, nämlich eine Unterbrechung, erfasst. Somit können auch Störungen, die die Überbrückungsleitung 19 betreffen, erkannt werden, sobald diese relevant sind.

Die Erfindung ist nicht auf die beschriebenen Ausführungsbeispiele beschränkt.

## Patentansprüche

1. Überwachungsanlage (1) für Personentransportanlagen (2), die als Aufzug, Rolltreppe oder Fahrsteig ausgestaltet sind, mit zumindest einer Abfrageeinrichtung (5) und zumindest einem über einen elektrischen Sicherheitskreis (13) mit der Abfrageeinrichtung (5) verbundenen Sicherheitsschalter (7), der zur Überwachung einer Einrichtung (15) der Personentransporteinrichtung (2) dient, wobei
• der Sicherheitsschalter (7) eine erste Schaltstellung und eine zweite Schaltstellung aufweist,
• zur Überprüfung des elektrischen Sicherheitskreises (13) im elektrischen Sicherheitskreis (13) eine stromrichtungsabhängige Einheit (8) angeordnet ist,
• mittels der Abfrageeinrichtung (5) eine Prüfspannung mit einer wechselnden Polarität an den elektrischen Sicherheitskreis (13) anlegbar ist,
• durch die Abfrageeinrichtung (5) mindestens ein durch die Prüfspannung ermittelbarer Zustand des elektrischen Sicherheitskreises (13) erfassbar ist und
• aus dem mindestens einen, durch die Abfrageeinrichtung (5) erfassten Zustand und aus der, diesem Zustand zugehörenden Schaltstellung des Sicherheitsschalters (7) mindestens ein Zustandssignal generierbar ist,
**dadurch gekennzeichnet, dass** in einer ersten Schaltstellung beziehungsweise einer ersten Abfolge der Schaltstellungen des zumindest einen Sicherheitsschalters (7, 20, 21) der elektrische Sicherheitskreis (13) über die stromrichtungsabhängige Einheit (8) geschlossen ist.

2. Überwachungsanlage (1) nach Anspruch 1, wobei die Abfrageeinrichtung (5) ausgestaltet ist, die Prüfspannung in Form einer Wechselspannung durchgehend oder in gewissen Zeitabständen an den elektrischen Sicherheitskreis (13) anzulegen.

3. Überwachungsanlage (1) nach Anspruch 1 oder 2, wobei über eine Steuereinrichtung (6) eine Testroutine für die Abfrageeinrichtung (5) durchführbar ist, in der in jeder zu testenden Schaltstellung beziehungsweise Abfolge von Schaltstellungen des zumindest einen Sicherheitsschalters (7, 20, 21) die Prüfspannung mit der wechselnden Polarität an den elektrischen Sicherheitskreis angelegt wird.

4. Überwachungsanlage (1) nach einem der Ansprüche 1 bis 3, wobei der elektrische Sicherheitskreis (13) eine Mehrzahl von Sicherheitsschaltern (7, 20, 21) aufweist und die stromrichtungsabhängige Einheit (8) an einem letzten Sicherheitsschalter (7) angeordnet ist, dass der letzte Sicherheitsschalter (7) der einzige Sicherheitsschalter (7) des elektrischen Sicherheitskreises (13) oder der letzte Sicherheitsschalter (7) einer Reihe (22) von mehreren Sicherheitsschaltern (7, 20, 21) ist, die in einer Hinleitung (11) des elektrischen Sicherheitskreises (13) angeordnet sind, und dass in der ersten Schaltstellung des letzten Sicherheitsschalters (7) beziehungsweise der ersten Abfolge der Schaltstellungen der Reihe (22) von mehreren Sicherheitsschaltern (7, 20, 21) die Hinleitung (11) über die stromrichtungsabhängige Einheit (8) zum Schließen des elektrischen Sicherheitskreises (13) mit einer Rückleitung (12) verbunden ist.

5. Überwachungsanlage (1) nach Anspruch 4, wobei in der Reihe (22) mit den mehreren Sicherheitsschaltern (7, 20, 21) nur an dem letzten Sicherheitsschalter (7) die stromrichtungsabhängige Einheit (8) angeordnet ist und/oder dass in der zweiten Schaltstellung des letzten Sicherheitsschalters (7) beziehungsweise in einer anderen Abfolge der Schaltstellungen der Reihe (22) von mehreren Sicherheitsschaltern (7, 20, 21), die sich von der ersten Abfolge unterscheidet, die Hinleitung (11) unterbrochen ist.

6. Überwachungsanlage (1) nach Anspruch 5, wobei mit der einen Polarität der Prüfspannung geprüft wird, ob alle Sicherheitsschalter (7, 20, 21) geschlossen sind oder ob zumindest ein Sicherheitsschalter (7, 20, 21) geöffnet ist, und dass mit beiden Polaritäten der Prüfspannung geprüft wird, ob eine Störung des elektrischen Sicherheitskreises (13) vorliegt.

7. Überwachungsanlage (1) nach Anspruch 4 oder 5, wobei eine weitere stromrichtungsabhängige Einheit (18) angeordnet ist, dass in einer zweiten Schaltstellung des letzten Sicherheitsschalters (7) beziehungsweise in einer anderen Abfolge der Schaltstellungen der Reihe (22) von mehreren Sicherheitsschaltern (7, 20, 21), die sich von der ersten Abfolge unterscheidet, ein mit der Abfrageeinrichtung (5) verbundener Teil der Hinleitung (11) auf eine Überbrückungsleitung (19) geschaltet ist, so dass die stromrichtungsabhängige Einheit (8) überbrückt ist und die Überbrückungsleitung (19) über die weitere stromrichtungsabhängige Einheit (18) mit der Rückleitung (12) verbunden ist.

8. Überwachungsanlage (1) nach Anspruch 7, wobei die stromrichtungsabhängige Einheit (8) und die weitere stromrichtungsabhängige Einheit (18) einen Stromfluss durch die Rückleitung (12) bei zueinander entgegen gesetzten Polaritäten der Prüfspannung sperren.

9. Überwachungsanlage (1) nach Anspruch 7 oder 8, wobei die stromrichtungsabhängige Einheit (8) direkt an einem ersten Ausgang (10) des letzten Sicherheitsschalters (7) angeordnet ist und/oder dass die weitere stromrichtungsabhängige Einheit (18) direkt an dem zweiten Ausgang (16) des letzten Sicherheitsschalters (7) angeordnet ist und/oder dass die stromrichtungsabhängige Einheit (8) eine erste Diode (8) aufweist und/oder dass die weitere stromrichtungsabhängige Einheit (18) eine zweite Diode (18) aufweist.

10. Überwachungsanlage (1) nach einem der Ansprüche 1 bis 9, wobei die Überwachungsanlage (1) eine dezentrale Steuereinrichtung (6) aufweist, die die Abfrageeinrichtung (5) umfasst oder die an der Abfrageeinrichtung (5) angeordnet ist, und dass die dezentrale Steuereinrichtung (6) über ein Bussystem (4) mit einer zentralen Steuerung (3) verbunden ist.

11. Überwachungsanlage (1) nach einem der Ansprüche 1 bis 9, wobei die Überwachungsanlage (1) eine zentrale Steuereinrichtung (6) aufweist, die die Abfrageeinrichtung (5) umfasst oder die an der Abfrageeinrichtung (5) angeordnet ist, und dass die Sicherheitsschalter (7, 20, 21) an der Abfrageeinrichtung (5) und/oder dezentral verteilt angeordnet sind.

12. Personentransportanlage (2), die als Aufzug, Rolltreppe oder Fahrsteig ausgestaltet ist, mit einer Überwachungsanlage (1) nach einem der Ansprüche 1 bis 11 und zumindest einer zu überwachenden Einrichtung (15, 33, 34), der ein Sicherheitsschalter (7, 20, 21) der Überwachungsanlage (1) zugeordnet ist.

13. Verfahren zur Überwachung einer Personentransportanlage (2), die als Aufzug, Rolltreppe oder Fahrsteig ausgestaltet ist, wobei durch zumindest einen Sicherheitsschalter (7, 20, 21) zumindest eine Einrichtung (15, 33, 34) der Personentransportanlage (2) überwacht wird, wobei über einen elektrischen Sicherheitskreis (13) eine Schaltstellung beziehungsweise eine Abfolge von Schaltstellungen des zumindest einen Sicherheitsschalters (7, 20, 21) abgefragt wird und wobei eine Abfrage des elektrischen Sicherheitskreises (13), in dem eine stromrichtungsabhängige Einheit (8) angeordnet ist, durch eine Prüfspannung mit einer wechselnden Polarität erfolgt, **dadurch gekennzeichnet, dass** in einer ersten Schaltstellung beziehungsweise einer ersten Abfolge der Schaltstellungen des zumindest einen Sicherheitsschalters (7, 20, 21) der elektrische Sicherheitskreis (13) über die stromrichtungsabhängige Einheit (8) geschlossen ist.

14. Verfahren nach Anspruch 13, wobei mit einer Polarität der Prüfspannung geprüft wird, ob alle Sicherheitsschalter (7, 20, 21) geschlossen sind und mit der anderen Polarität geprüft wird, ob zumindest ein Sicherheitsschalter (7, 20, 21) geöffnet ist, und dass mit beiden Polaritäten der Prüfspannung geprüft wird, ob eine Störung des elektrischen Sicherheitskreises (13) vorliegt.

## Claims

1. Monitoring system (1) for passenger transport installations (2), which are designed as an elevator, escalator or moving walkway, with at least one interrogation device (5) and at least one safety switch (7), which is connected with the interrogation device (5) by way of an electrical safety circuit (13) and which serves for monitoring an item of equipment (15) of the passenger transport installation (2), wherein
- the safety switch (7) has a first switch setting and a second switch setting,
- a unit (8) with current direction dependence for checking the electrical safety circuit (13) is arranged in the electrical safety circuit (13),
- a test voltage with alternating polarity can be applied to the electrical safety circuit (13) by means of the interrogation device (5),
- at least one state of the electrical safety circuit (13), which is determinable by the test voltage, is detectable by the interrogation device (5) and
- from the at least one state which is detected by the interrogation device (5) and from the switch setting which belongs to this state of the safety switch (7), at least one status signal can be generated,
**characterised in that** the electrical safety circuit (13) is closed by way of the unit (8) with current direction dependence in a first switch setting or a first sequence of the switch settings of the at least one safety switch (7, 20, 21).

2. Monitoring system (1) according to claim 1, wherein the interrogation device (5) is designed to apply the test voltage in the form of an alternating voltage to the electrical safety circuit (13) continuously or at specific intervals in time.

3. Monitoring system (1) according to claim 1 or 2, wherein a test routine for the interrogation device (5) can be performed by way of a control device (6), in which test routine the test voltage with the alternating polarity is applied to the electrical safety circuit in each switch setting to be tested or each sequence of switch settings to be tested of the at least one safety switch (7, 20, 21).

4. Monitoring system (1) according to any one of claims 1 to 3, wherein the electrical safety circuit (13) comprises a plurality of safety switches (7, 20, 21) and the unit (8) with current direction dependence is arranged at a last safety switch (7), that the last safety switch (7) is the sole safety switch (7) of the electrical safety circuit (13) or the last safety switch (7) of a series (22) of several safety switches (7, 20, 21) arranged in a forward line (11) of the electrical safety circuit (13), and that in the first switch setting of the last safety switch (7) or the first sequence of the switch settings of the series (22) of several safety switches (7, 20, 21) the forward line (11) is connected with a return line (12) by way of the unit (8) with current direction dependence for closing the electrical safety circuit (13).

5. Monitoring system (1) according to claim 4, wherein the unit (8) with current direction dependence is arranged in the series (22) with the several safety switches (7, 20, 21) only at the last safety switch (7) and/or that the forward line (11) is interrupted in the second switch setting of the last safety switch (7) or in another sequence of the switch settings of the series (22) of several safety switches (7, 20, 21) differing from the first sequence.

6. Monitoring system (1) according to claim 5, wherein it is checked by one polarity of the test voltage whether all safety switches (7, 20, 21) are closed or whether at least one safety switch (7, 20, 21) is open and it is checked by the two polarities of the test voltage whether a disturbance of the electrical safety circuit (13) is present.

7. Monitoring system (1) according to claim 4 or 5, wherein a further unit (18) with current direction dependence is arranged, that in a second switch setting of the last safety switch (7) or in another sequence of the switch settings of the series (22) of several safety switches (7, 20, 21) differing from the first sequence a part of the forward line (11) connected with the interrogation device (5) is connected with a bridging-over line (19) so that the unit (8) with current direction dependence is bridged over and the bridging-over line (19) is connected with the return line (12) by way of the further unit (18) with current direction dependence.

8. Monitoring system (1) according to claim 7, wherein the unit (8) with current direction dependence and the further unit (18) with current direction dependence block current flow through the return line (12) in the case of mutually opposite polarities of the test voltage.

9. Monitoring system (1) according to claim 7 or 8, wherein the current unit (8) with current direction dependence is arranged directly at a first output (10) of the last safety switch (7) and/or that the further unit (18) with current direction dependence is arranged directly at the second output (16) of the last safety switch (7) and/or that the unit (8) with current direction dependence comprises a first diode (8) and/or that the further unit (18) with current direction dependence comprises a second diode (18).

10. Monitoring system (1) according to any one of claims 1 to 9, wherein the monitoring system (1) comprises a decentral control device (6), which comprises the interrogation device (5) or which is arranged at the interrogation device (5), and that the decentral control device (6) is connected with a central control (3) by way of a bus system (4).

11. Monitoring system (1) according to any one of claims 1 to 9, wherein the monitoring system (1) comprises a central control device (6), which comprises the interrogation device (5) or is arranged at the interrogation device (5), and that the safety switches (7, 20, 21) are arranged at the interrogation device (5) and/or in decentral distribution.

12. Passenger transport installation (2), which is designed as an elevator, escalator or moving walkway, with a monitoring system (1) according to any one of claims 1 to 11 and at least one item of equipment (15, 33, 34) which is to be monitored and with which a safety switch (7, 20, 21) of the monitoring (1) system is associated.

13. Method of monitoring a passenger transport installation (2), which is designed as an elevator, escalator or moving walkway, wherein at least one item of equipment (15, 33, 34) of the passenger transport installation (2) is monitored by at least one safety switch (7, 20, 21), wherein a switch setting or a sequence of switch settings of the at least one safety switch (7, 20, 21) is interrogated by way of an electrical safety circuit (13) and wherein interrogation of the electrical safety circuit (13), in which a unit (8) with current direction dependence is arranged, is carried out by a test voltage with an alternating polarity, **characterised in that** in a first switch setting or a first sequence of the switch settings of the at least one safety switch (7, 20, 21) the electrical safety circuit (13) is closed by way of the unit (8) with current direction dependence.

14. Method according to claim 13, wherein it is checked by one polarity of the test voltage whether all safety switches (7, 20, 21) are closed, by the other polarity whether at least one safety switch (7, 20, 21) is open and by both polarities of the test voltage whether a disturbance of the electrical safety circuit (13) is present.

## Revendications

1. Installation de surveillance (1) pour installations de transport de personnes (2) qui sont conçues comme un ascenseur, un escalier roulant ou un trottoir roulant, avec au moins un dispositif d'interrogation (5) et au moins un commutateur de sécurité (7) qui est relié au dispositif d'interrogation (5) par l'intermédiaire d'un circuit électrique de sécurité (13) et qui sert à surveiller un dispositif (15) du dispositif de transport de personnes (2),
• le commutateur de sécurité (7) présentant une première position de commutation et une seconde position de commutation,
• une unité (8) dépendante du sens du courant étant disposée dans le circuit de sécurité électrique (13) pour contrôler celui-ci,
• une tension de contrôle avec une polarité alternée pouvant être appliquée au circuit de sécurité électrique (13) à l'aide du dispositif d'interrogation (5),
• au moins un état du circuit de sécurité électrique (13) apte à être déterminé par la tension de contrôle pouvant être détecté par le dispositif d'interrogation (5), et
• au moins un signal d'état pouvant être généré à partir de l'état ou des états détectés par le dispositif d'interrogation (5) et à partir de la position de commutation, correspondant à cet état, du commutateur de sécurité (7),
**caractérisé en ce que** dans une première position de commutation ou dans une première succession des positions de commutation du ou des commutateurs de sécurité (7, 20, 210), le circuit électrique (13) est fermé par l'intermédiaire de l'unité (8) dépendante du sens du courant.

2. Installation de surveillance (1) selon la revendication 1, le dispositif d'interrogation (5) étant conçu pour appliquer la tension de contrôle au circuit de sécurité électrique (13) sous la forme d'une tension alternée, de manière ininterrompue ou avec une certaine périodicité.

3. Installation de surveillance (1) selon la revendication 1 ou 2, une routine de test pour le dispositif d'interrogation (5) pouvant être effectuée par l'intermédiaire d'un dispositif de commande (6), routine dans laquelle dans chaque position de commutation ou succession de positions de commutation à tester du ou des commutateurs de sécurité (7, 20, 21), la tension de contrôle avec une polarité alternée est appliquée au circuit de sécurité électrique.

4. Installation de surveillance (1) selon l'une des revendications 1 à 3, le circuit de sécurité électrique (13) comportant plusieurs commutateurs de sécurité (7, 20, 21), et l'unité (8) dépendante du sens de courant étant disposée sur un dernier commutateur de sécurité (7), le dernier commutateur de sécurité (7) étant le seul commutateur de sécurité (7) du circuit de sécurité électrique (13) ou le dernier commutateur de sécurité (7) d'une série (22) de plusieurs commutateurs de sécurité (7, 20, 21) qui sont disposés dans une ligne d'amenée (11) du circuit de sécurité électrique (13), et dans la première position de commutation du commutateur de sécurité (7) ou dans la première succession des positions de commutation de la série (22) de plusieurs commutateurs de sécurité (7, 20, 21) la ligne d'amenée (11) étant reliée à une ligne de retour (12) par l'intermédiaire d'une unité (8) dépendante du sens du courant, pour fermer le circuit de sécurité électrique (13).

5. Installation de surveillance (1) selon la revendication 4, dans laquelle dans la série (22) de plusieurs commutateurs de sécurité (7, 20, 21), l'unité (8) dépendante du sens du courant est disposée seulement sur le dernier commutateur de sécurité (7), et/ou dans la seconde position de commutation du dernier commutateur de sécurité ou dans une autre succession des positions de commutation de la série (22) de plusieurs commutateurs de sécurité (7, 20, 21) qui se distingue de la première succession, la ligne d'amenée (11) est interrompue.

6. Installation de surveillance (1) selon la revendication 5, dans laquelle avec une polarité de la tension de contrôle, on vérifie si tous les commutateurs de sécurité (7, 20, 21) sont fermés ou si au moins un commutateur de sécurité (7) est ouvert, et avec les deux polarités de la tension de contrôle, on vérifie s'il y a une défaillance du circuit de sécurité électrique (13).

7. Installation de surveillance (1) selon la revendication 4 ou 5, dans laquelle une autre unité (18) dépendante du sens du courant est prévue, et dans une seconde position de commutation du dernier commutateur de sécurité (7) ou dans une autre succession des positions de commutation de la série (22) de plusieurs commutateurs de sécurité (7, 20, 21) qui se distingue de la première succession, une partie de la ligne d'amenée (11) reliée au dispositif d'interrogation (5) est montée sur une ligne de court-circuit (19), de sorte que l'unité (8) dépendante du sens du courant est court-circuitée et que la ligne de court-circuit (19) est reliée par l'intermédiaire de l'autre unité (18) dépendante du sens du courant à la ligne de retour (12).

8. Installation de surveillance (1) selon la revendication 7, l'unité (8) dépendante du sens du courant et l'autre unité (18) dépendante du sens du courant bloquant un courant à travers la ligne de retour (12) en présence de polarités opposées de la tension de contrôle.

9. Installation de surveillance (1) selon la revendication 7 ou 8, l'unité (8) dépendante du sens du courant étant disposée directement à une première sortie (10) du dernier commutateur de sécurité (7), et/ou l'autre unité (18) dépendante du sens du courant étant disposée directement à la seconde sortie (16) du dernier commutateur de sécurité (7), et/ou l'unité (8) dépendante du sens du courant comportant une première diode (8), et/ou l'autre unité (18) dépendante du sens du courant comportant une seconde diode (18).

10. Installation de surveillance (1) selon l'une des revendications 1 à 9, l'installation de surveillance (1) comportant un dispositif de commande décentralisé (6) qui comprend le dispositif d'interrogation (5) ou qui est disposé sur le dispositif d'interrogation (5), et la disposition de commande décentralisé (6) étant relié par un système de bus (4) à la commande centrale (3).

11. Installation de surveillance (1) selon l'une des revendications 1 à 9, l'installation de surveillance (1) comportant un dispositif de commande central (6) qui comprend le dispositif d'interrogation (5) ou qui est disposé sur le dispositif d'interrogation (5), et les commutateurs de sécurité (7, 20, 21) étant disposés sur le dispositif d'interrogation (5) ou répartis de manière décentralisée.

12. Installation de transport de personnes (2) conçue comme un ascenseur, un escalier roulant ou un trottoir roulant, avec une installation de surveillance (1) selon l'une des revendications 1 à 11 et au moins un dispositif à surveiller (15, 33, 34) auquel est associé un commutateur de sécurité (7, 20, 21) de l'installation de surveillance (1).

13. Procédé pour surveiller une installation de transport de personnes (2) qui est conçue comme un ascenseur, un escalier roulant ou un trottoir roulant, au moins un dispositif (15, 33, 34) de l'installation de transport de personnes (2) étant surveillé grâce à au moins un commutateur de sécurité (7, 20, 21), une position de commutation ou une succession de positions de commutation du ou des commutateurs de sécurité (7, 20, 21) étant interrogée par l'intermédiaire d'un circuit de sécurité électrique (13), et une interrogation dudit circuit de sécurité électrique (13) dans lequel est disposée l'unité (8) dépendante du sens du courant ayant lieu grâce à une tension de contrôle avec une polarité alternée,
**caractérisé en ce que** dans une première position de commutation ou dans une première succession des positions de commutation du ou des commutateurs de sécurité (7, 20, 210), le circuit électrique (13) est fermé par l'intermédiaire de l'unité (8) dépendante du sens du courant.

14. Procédé selon la revendication 13, selon lequel avec une polarité de la tension de contrôle, on vérifie si tous les commutateurs de sécurité (7, 20, 21) sont fermés, tandis qu'avec l'autre polarité, on vérifie si au moins un commutateur de sécurité (7) est ouvert, et avec les deux polarités de la tension de contrôle, on vérifie s'il y a une défaillance du circuit de sécurité électrique (13).
